(19) Europäisches Patentamt
European Patent Office
Office européen des brevets

(11) **EP 1 290 765 B1**

(12) **EUROPEAN PATENT SPECIFICATION**

(45) Date of publication and mention
of the grant of the patent:
**25.08.2004 Bulletin 2004/35**

(51) Int Cl.7: **H01S 5/125**, H01S 5/0625

(86) International application number:
**PCT/US2001/017884**

(21) Application number: **01944233.4**

(22) Date of filing: **01.06.2001**

(87) International publication number:
**WO 2001/095444 (13.12.2001 Gazette 2001/50)**

(54) **HIGH-POWER SAMPLED GRATING DISTRIBUTED BRAGG REFLECTOR LASERS**

HOCHLEISTUNGSLASER MIT GESAMPELTEM GITTER UND VERTEILTEM BRAGG-REFLEKTOR

LASERS HAUTE PUISSANCE MANUFACTURABLES A REFLECTEUR BRAGG REPARTI ET A RESEAU ECHANTILLONNE

(84) Designated Contracting States:
**AT BE CH CY DE DK ES FI FR GB GR IE IT LI LU MC NL PT SE TR**

(30) Priority: **02.06.2000 US 209068 P**
**12.07.2000 US 614224**
**12.07.2000 US 614377**
**12.07.2000 US 614376**
**12.07.2000 US 614378**
**12.07.2000 US 614895**
**12.07.2000 US 614375**
**12.07.2000 US 614195**
**12.07.2000 US 614665**
**12.07.2000 US 614674**

(43) Date of publication of application:
**12.03.2003 Bulletin 2003/11**

(73) Proprietor: **Agility Communications, Inc.**
**Goleta, CA 93117 (US)**

(72) Inventors:
• **COLDREN, Larry, A.**
**Santa Barbara, CA 93110 (US)**
• **FISH, Gregory, A.**
**Santa Barbara, CA 93111 (US)**
• **LARSON, Michael, C.**
**Santa Barbara, CA 93105 (US)**

(74) Representative: **McGowan, Cathrine**
**D Young & Co,**
**21 New Fetter Lane**
**London EC4A 1DA (GB)**

(56) References cited:
**EP-A- 1 172 905**          **US-A- 5 088 097**
**US-A- 5 790 581**          **US-A- 5 841 799**

EP 1 290 765 B1

## Description

CROSS-REFERENCE TO RELATED APPLICATIONS

This application claims the benefit under 35 U. S.C. §119(e) of the following co-pending and commons-assigned U.S. provisional patent application Serial No. 60/209,068, filed June 2, 2000, by Larry A. Coldren et al., and entitled "HIGH-POWER, MANUFACTURABLE SAMPLED-GRATING DBR LASERS," attorneys' docket number 122.2-US-P1.

This application is a continuation-in-part of the following co-pending and commonly-assigned U.S. utility patent applications:

Serial No. 09/614,224, filed July, 12, 2000, by Larry A. Coldren et aL, and entitled "METHOD OF MAKING A TUNABLE LASER SOURCE WITH INTEGRATED OPTICAL AMPLIFIER" (now U.S. Patent No. 6,654,400 issued November 25, 2003);

Serial No. 09/614,377, filed July, 12, 2000. by Larry A. Coldren, and entitled "INTEGRATED OPTO-ELECTRONIC WAVELENGTH CONVERTER ASSEMBLY" (now U.S. Patent No. 6,580,739 issued June 17, 2003);

Serial No. 09/614,376, filed July, 12, 2000, by Larry A. Coldren et al., and entitled "METHOD OF CONVERTING AN OPTICAL WAVELENGTH WITH AN OPTO-ELECTRONIC LASER WITH INTEGRATED MODULATOR" (now U.S. Patent No. 6,614,819 issued September 2, 2003);

Serial No. 09/614,378, filed July, 12, 2000, by Larry A. Coldren et al., and entitled "OPTO-ELECTRONIC LASER WITH INTEGRATED MODULATOR" (now U.S. Patent No. 6,628,690 issued September 30, 2003);

Serial No. 09/614,895, filed July, 12, 2000. by Larry A. Coldren, and entitled "METHOD FOR CONVERTING AN OPTICAL WAVELENGTH USING A MONOLITHIC WAVELENGTH CONVERTER ASSEMBLY" (now U.S. Patent No. 6,349,106 issued February 19, 2002);

Serial No. 09/614,375, filed July, 12, 2000, by Larry A. Coldren et al., and entitled "TUNABLE LASER SOURCE WITH INTEGRATED OPTICAL AMPLIFIER" (now U.S. Patent No. 6,658,035 issued December 2, 2003);

Serial No. 09/614,195, filed July, 12, 2000, by Larry A. Coldren et al., and entitled "METHOD OF MAKING AND OPTO-ELECTRONIC LASER WITH INTEGRATED MODULATOR" (now U.S. Patent No. 6,574,259 issued June 3, 2003);

Serial No. 09/614,665, filed July, 12, 2000, by Larry A. Coldren et al., and entitled "METHOD OF GENERATING AN OPTICAL SIGNAL WITH A TUNABLE LASER SOURCE WITH INTEGRATED OPTICAL AMPLIFIER" (now U.S. Patent No. 6,687,278 issued February 3,2004); and

Serial No. 09/614,674, filed July, 12,2000, by Larry A. Coldren, and entitled "METHOD FOR MAKING A MONOLITHIC WAVELENGTH CONVERTER ASSEMBLY" (now U.S. Patent No. 6,624,000 issued September 23, 2003);

all of which are continuation-in-parts of the others, and all of which claim the benefit under 35 U.S.C. §119 (e) to the following U.S. provisional patent applications:

Serial No. 60/152,038, filed on September 2,1999, by Gregory Fish et al., and entitled "OPTOELECTRONIC LASER WITH INTEGRATED MODULATOR";
Serial No. 60/152,049, filed on September 2, 1999, by Larry Coldren, and entitled "INTEGRATED OPTOELECTRONIC WAVELENGTH CONVERTER"; and
Serial No. 60/152,072, filed on September 2, 1999, by Beck Mason et al., and entitled "TUNABLE LASER SOURCE WITH INTEGRATED OPTICAL AMPLIFIER".

BACKGROUND OF THE INVENTION

1. Field of the Invention.

The present invention relates generally to wide-range tunable semiconductor lasers and particularly to sampled-grating distributed Bragg reflector (SGDBR) lasers.

2. Description of the Related Art.

Diode lasers are being used in such applications as optical communications, sensors and computer systems. In such applications, it is very useful to employ lasers that can be easily adjusted to output frequencies across a wide wavelength range. A diode laser which can be operated at selectably variable frequencies covering a wide wavelength range, i.e. a widely tunable laser, is an invaluable tool. The number of separate channels that can be switched between by a laser source in a given wavelength range is exceedingly limited without such a laser. Accordingly, the number of individual communications paths that can exist simultaneously switched in a system employing such range-limited lasers is similarly very limited. Thus, while diode lasers have provided solutions to many problems in communications, sensors and computer system designs, they have not fulfilled their potential based on the available bandwidth afforded by light-based systems. It is important that the number of channels be increased and that they may be selectively utilized in order for optical systems to be realized for many future applications.

For a variety of applications, it is necessary to have tunable diode lasers which can be selectively configured to emit substantially one of a wide range of wavelengths. Such applications include transmission sources and local oscillators in coherent lightwave communications systems, sources for other multi-channel lightwave communication systems, and sources for use in frequency modulated sensor systems. Continuous tunability is usually needed over some range of wavelengths.

In addition, widely tunable semiconductor lasers, such as the sampled-grating distributed-Bragg-reflector (SGDBR) laser, the grating-coupled sampled-reflector (GCSR) laser, and vertical-cavity lasers with micro-mechanical moveable mirrors (VCSEL-MEMs) generally must compromise their output power in order to achieve a large tuning range. The basic function and structure of SGDBR lasers is detailed in U.S. Patent 4,896,325, issued January 23, 1990, to Larry A. Coldren, and entitled "MULTI-SECTION TUNABLE LASER WITH DIFFERING MULTI-ELEMENT MIRRORS". This document describes a tunable semiconductor laser comprising an active section, including a gain section and a phase shifter section, for creating and guiding a light beam between opposed ends of the active section, and a pair of mirrors bounding the active section, the mirrors having differently spaced narrow reflective maxima. Designs that can provide over 40 nm of tuning range have not been able to provide much more than a milliwatt or two of power out at the extrema of their tuning spectrum. However, current and future optical fiber communication systems as well as spectroscopic applications require output powers in excess of 10 mW over the full tuning range. The International Telecommunication Union (ITU) C-band is about 40 nm wide near 1.55 μm. There are other ITU bands as well that may be used including the L-band and the S-band.

It is desired to have a single component that can cover at least the entire C-band. Systems that are to operate at high bit rates may require more than 20 mW over the full ITU bands. Such powers are available from distributed feedback (DFB) lasers, but these can only be tuned by a couple of nanometers by adjusting their temperature. Thus, it is very desirable to have a source with both wide tuning range (> 40 nm) and high power (> 20 mW) without a significant increase in fabrication complexity over existing widely tunable designs.

The present invention discloses methods and devices of enhanced semiconductor laser, and particularly sampled-grating distributed Bragg reflector (SGDBR) lasers, which achieve high power over a wide tuning range and are manufactured using conventional techniques.

SUMMARY OF THE INVENTION

To address the issues described above, the present invention generally comprises a tunable laser comprising a gain section for creating a light beam through the well-known phenomena of spontaneous and stimulated emission over a bandwidth, a phase section for controlling the light beam around a center frequency of the bandwidth, a waveguide for guiding and reflecting the light beam in a cavity including a relatively low energy bandgap separate-confinement-heterostructure (SCH), a first or front mirror bounding an end of the cavity and a second or back mirror bounding an opposite end of the cavity wherein gain is provided by at least one of the group comprising the phase section, the front mirror and the back mirror.

Accordingly, a first aspect of the present invention, as defined in Claim 1, is directed to a sampled-grating distributed Bragg reflector (SGDBR) tunable laser comprising. a gain section for creating a light beam; a phase section for controlling the light beam around a center frequency of the bandwidth; a front distributed Bragg reflector (DBR) mirror bounding an end of the cavity; and a back distributed Bragg reflector (DBR) mirror bounding an opposite end of the cavity; a waveguide for guiding and reflecting the light beam in a cavity including a relatively low energy bandgap separate-confinement-heterostructure (SCH), the waveguide including the SCH being uniform across the gain and phase sections and the front and back mirrors and the SCH including centered shallow quantum wells; wherein gain for the light beam is provided by at least one of the group comprising the phase section, the front mirror and the back mirror.

A second aspect of the present invention, as defined in Claim 12, is directed to a method of producing a sampled-grating distributed Bragg reflector (SGDBR) semiconductor laser (100), comprising the steps of growing a waveguide layer for guiding and reflecting the light beam including a relatively low energy bandgap separate-confinement-heterostructure (SCH) region on a substrate including a gain section for creating a light beam, a phase section for controlling the light beam around a center frequency of the bandwidth, a front mirror bounding an end of the cavity and a back mirror bounding an opposite end of the cavity, the waveguide layer including the SCH being uniform across the gain and phase sections and the front and back mirrors and the SCH including centered shallow quantum wells; etching sampled grating grooves in the waveguide layer to form the front mirror and the back mirror; and growing upper cladding and contact layers on the waveguide layer; wherein gain is provided by at least one of the group comprising the phase section, the front mirror and the back mirror.

Embellishments on the SGDBR design provide widely tunable devices that provide generally higher power than earlier SGDBR lasers. In addition, most of the embodiments of the present invention are relatively simple to manufacture.

As will be illustrated in the drawings below, some embodiments of the present invention simplify the basic SGDBR design, since they use the same active waveguide material throughout the device length, rather than requiring the fabrication of abutted active and passive sections. However, other embodiments include a modification of the bandgap of the waveguide regions in the mirrors and phase-shift sections. This modification may be accomplished with a simple quantum-well disordering process, selective area growth, or regrowth techniques that are well-known to those skilled in the art In most cases the absorption edge of these sections needs be shifted only slightly, and thus, both the quantum-well disordering (or intermixing) and selective area growth procedures are easily accomplished. These latter processes also require no additional regrowth steps.

BRIEF DESCRIPTION OF THE DRAWINGS

Referring now to the drawings in which like reference numbers represent corresponding parts throughout

FIGS. 1A and 1B depict a SGDBR laser showing the four sections used to control the power and wavelength of the laser's emission;

FIG. 2 is a cross sectional schematic view of a first class of embodiments of the current invention;

FIG. 3 is a transverse schematic of the energy bands plotted across the SCH waveguide region for the first embodiment in which a single uniform quantum well SCH waveguide is used throughout the entire device length;

FIG. 4 illustrates the band structure at low and high carrier injection levels;

FIG. 5 illustrates the modal gain vs. energy for the carrier densities of FIG. 4;

FIG. 6 illustrates the modal index vs. carrier density;

FIG. 7 illustrates the band structure of an intermixed section in another embodiment of the invention; and

FIGS. 8A - 8B illustrate another embodiment in which three different bandgap regions are created.

DETAILED DESCRIPTION OF THE PREFERRED EMBODIMENTS

In the following description, reference is made to the accompanying drawings which form a part hereof, and in which is shown, by way of illustration, a preferred embodiment of the present invention. It is understood that other embodiments may be utilized and structural changes may be made without departing from the scope of the present invention.

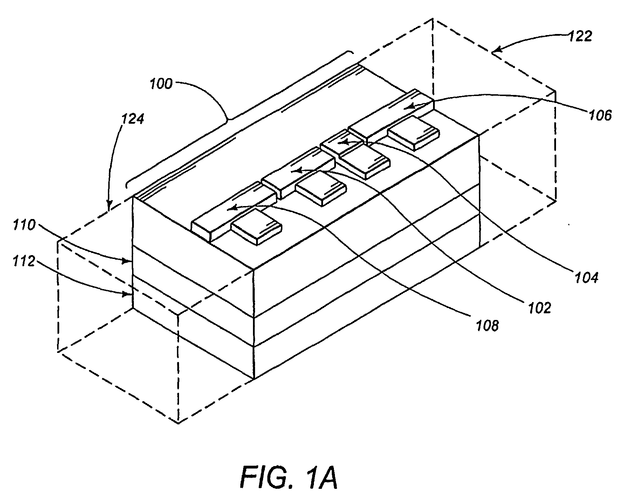

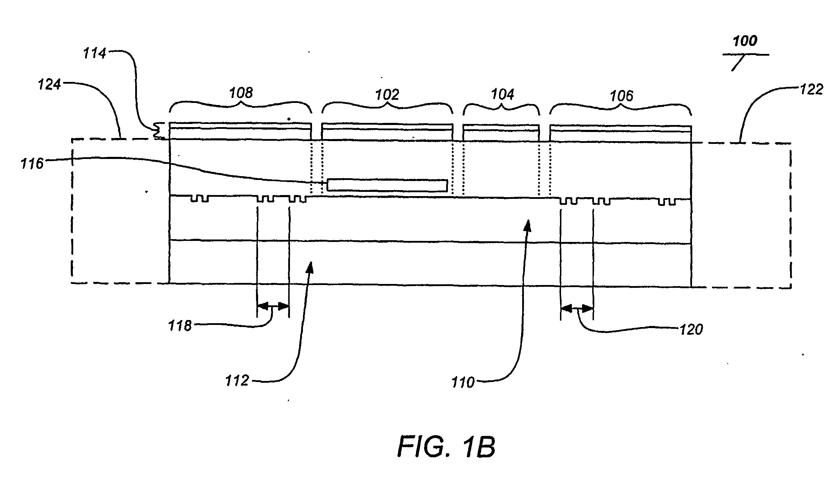

FIGS. 1A and 1B show a typical SGDBR laser illustrating the four sections that allow its unique tuning characteristics. The laser 100 is comprised of a gain section 102, a phase section 104, a first or front mirror 108 and a second or back mirror 106. Preferably disposed below these sections is a waveguide 110 for guiding and reflecting the light beam, while the entire device is formed on a substrate 112. In use, generally bias voltages are connected to electrodes 114 on the top of the device and a ground is connected to a lower substrate 112. When a bias voltage on the gain section 102 is above a lasing threshold, a laser output is produced from an active region 116.

The front and back mirrors 108,106 are typically sampled grating mirrors that respectively include different sampling periods 118, 120. The gratings behave as wavelength-selective reflectors such that partial reflections are produced at periodic wavelength spacings of an optical signal carried in the cavity. The front and back sampled grating mirrors 108. 106 together determine the wavelength with the minimum cavity loss through their effective lengths and grating differential, however, the lasing wavelength can only occur at the longitudinal modes of the optical cavity in the waveguide 110. Therefore, it is important to adjust the mirrors 106, 108 and waveguide 110 modes to coincide, thereby achieving the lowest cavity loss possible for the desired wavelength. The phase section 104 of the device shown in FIG. 1 is used to adjust the optical length of the cavity in order to position the cavity modes.

Optional back-side monitor 122 and front-side semiconductor optical amplifier (SOA) and/or optical modulator 124 sections are also indicated. Currents are applied to the various electrodes 114 of the aforementioned sections to provide a desired output optical power and wavelength as discussed in U.S. Patent 4,896,325, issued January 23, 1990, to Larry A. Coldren, and entitled "MULTI-SECTION TUNABLE LASER WITH DIFFERING MULTI-ELEMENT MIRRORS". As described therein, a current to the gain section 102 creates light and provides gain to overcome losses in the laser cavity; currents to the two differing SGDBR wavelength-selective minors 106,108 are used to tune a net low-loss window across a wide wavelength range to select a given mode; and a current to the phase section 104 provides for a fine tuning of the mode wavelength. It should also be understood that the sections are somewhat interactive, so that currents to one section will have some effect on the parameters primarily controlled by the others.

Currents and voltages are applied and/or monitored at the optional sections to monitor power or wavelength, or provide amplification or modulation as specified in the following U.S. utility patent applications: Serial No. 09/614,224, filed July, 12, 2000, by Larry A. Coldren et al., and entitled "METHOD OF MAKING A TUNABLE LASER SOURCE WITH INTEGRATED OPTICAL AMPLIFIER" (now U.S.Patent No. 6,654,400 issued November 20, 2003); serial No. 09/614,377, filed July 12, 2000 by Larry A. Coldren, and entitled "INTEGRATED OPTO-ELECTRONIC WAVELENGTH CONVERTER ASSEMBLY" (now U.S. Patent No. 6,580,739 issued June 17, 2003); Serial No. 09/614,376, filed July, 12, 2000, by Larry A. Coldren et aL and entitled "METHOD OF CONVERTING AN OPTICAL WAVELENGTH WITH AN OPTO-ELECTRONIC LASER WITH INTEGRATED MODULATOR" (now U.S. Patent No. 6,614,819 issued September 2, 2003); Serial No. 09/614,378, filed July, 12, 2000, by Larry A. Coldren et al., and entitled "OPTO-ELECTRONIC LASER WITH INTEGRATED MODULATOR" (now U.S. Patent No. 6,628,690 issued September 30, 2003) ; Serial No. 09/614,895, filed July, 12, 2000, by Larry A. Coldren, and entitled "METHOD FOR CONVERTING AN OPTICAL WAVELENGTH USING A MONOLITHIC WAVELENGTH CONVERTER ASSEMBLY" (now U.S. Patent No. 6,349,106 issued February 19, 2002); Serial No. 09/614,195 filed July, 12, 2000, by Larry A. Coldren et al., and ASSEMBLY" (now U.S. Patent No. 6,349,106 issued February 19, 2002); Serial No. 09/614,375, filed July, 12, 200 , by Larry A. Coldren et al., and entitled "TUNABLE LASER SOURCE WITH INTEGRATED OPTICAL AMPLIFIER" (now U.S. Patent No. 6,658,035 issued December 2, 2003); Serial No. 09/614,195, filed July, 12, 2000, by Larry A. Coldren et al., and entitled "METHOD OF MAKING AN] LASER WITH INTEGRATED MODULATOR" (now U.S. Patent No. 6,574,259 issued June 3, 2003); Serial No. 09/614,665, filed July, 12, 2000, by Larry A. Coldren et al., and entitled "METHOD OF GENERATING AN OPTICAL SIGNAL WITH A TUNABLE LASER SOURCE WITH INTEGRATED OPTICAL AMPLIFIER" (now U.S. Patent No. 6,687,278 issued February 3, 2004); and Serial No. 09/614,674, filed July, 12, 2000, by Larry A. Coldren, and entitled "METHOD FOR MAKING A MONOLITHIC WAVELENGTH CONVERTER ASSEMBLY" (now U.S. Patent No. 6,624,000 issued September 23, 2003); all of which are continuation-in-parts of the others, and all of which claim the benefit under 35 U.S.C. §119(e) to the following U. S. provisional patent applications: Serial No. 60/152,038, filed on September 2, 1999, by Gregory Fish et aL, and entitled "OPTOELECTRONIC LASER WITH INTEGRATED MODULATOR"; Serial No. 60/152,049, filed on September 2,1999, by Larry Coldren, and entided "INTEGRATED OPTOELECTRONIC WAVELENGTH CONVERTER"; and Serial No. 60/152,072, filed on September 2,1999, by Beck Mason et al., and entitled "TUNABLE LASER SOURCE WITH INTEGRATED OPTICAL AMPLIFIER." The current invention operates under the same general principles and techniques as these previous background inventions.

An important aspect of the present invention is to provide gain in the SGDBR mirror and/or phase shift sections to offset the loss that normally accompanies tuning by carrier injection. Another key aspect is to provide this gain in a configuration that has higher saturation power than the 5 to 10 mW that is typical of quantum-well active regions in the 1.5 to 1.6 μm wavelength range. The various embodiments of the current invention provide a combination of these two aspects, enabling devices with much higher output powers than achievable without these improvements.

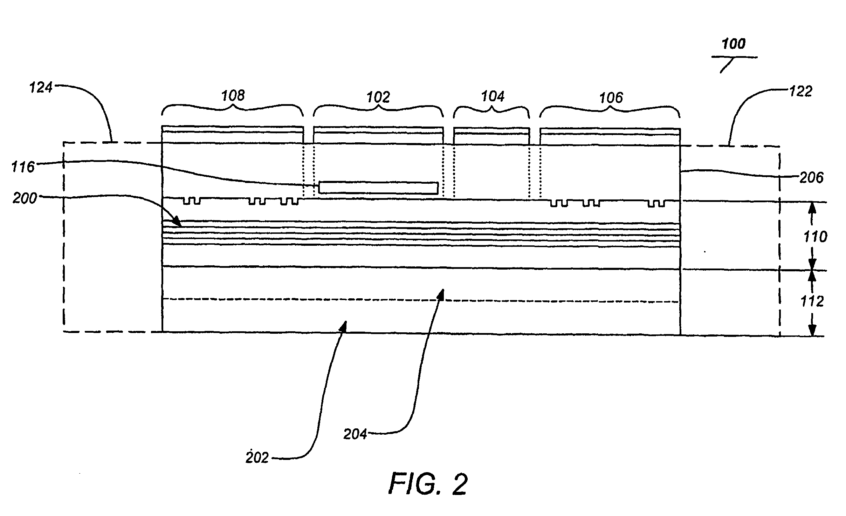

FIG. 2 is a cross sectional schematic view of a first class of embodiments of the current invention. Optional back-side monitor 122 and front side semiconductor optical ampliner (SOA) and/or optical modulator 124 sections are again indicated. Not indicated, is the optional disordering or intermixing of the quantum-well gain regions in the phase 104, back mirror 106, or front mirror 108 sections which provides for additional optimization of the laser 100. As illustrated, the device contains a common waveguide layer 110 that extends along its entire length. Thus, there are no optical discontinuities to cause unwanted reflections. This is true even if the optional quantum-well intermixing step is added, since the intermixing causes no net change in the modal index of refraction. Also, the simplicity of this cross section illustrates the relative simplicity of the fabrication sequence, which only requires one regrowth step to form the buried gratings for the mirrors 106,108. However, an additional regrowth may be desirable for lateral optical waveguiding and current confinement.

The first embodiment uses a common active waveguide 110 throughout the length of the device. This waveguide 110 consists of a relatively low energy bandgap separate-confinement-heterostructure (SCH) 200 that contains centered shallow quantum wells. This structure is optimized such that gain builds up rapidly in the quantum wells as carriers are injected to a level roughly equal to that required for the device threshold. At this point, the shallow quantum wells are filled, and some carriers are already spilling out into the SCH region 200. Thus, with additional carrier injection the gain tends to saturate, having only a slight increase in the desired optical band as additional injected carriers fill the higher bandgap SCH region 200. However, the build up of carriers in the SCH will provide a desirable index of refraction change. Thus, by altering the relative biases of the various SGDBR laser sections 102 - 108, the various indexes can be adjusted while the net gain still remains at its required threshold value. Also, since the differential gain (slope of gain versus carrier density) is relatively low above the gain roll-over point, the saturation power tends to be much higher.

The build-up of carriers in the SCH region 200 would normally be accompanied by a net free-carrier absorption loss, but in this case, this is partially or fully compensated by the slight increases in modal gain with additional carriers. These increases are enhanced due to band shrinkage, a well known many-body effect that tends to reduce the bandgap energy as a large carrier density is obtained. Thus, the free-carrier absorption associated with the build up of carriers in the SCH region 200 is also at least partially compensated by band-to-band stimulated emission that can now occur in the reduced bandgap SCH region at high carrier densities. Because gain is being provided only at the low energy edge of this population, the saturation power is again enhanced. To achieve this desired operation, the bandgaps and numbers of quantum-wells as well as the bandgap and width of the SCH region must be carefully specified.

Other embodiments of the present invention include a modification of the absorption and gain properties of one or more of the phase 104, front mirror 108 or back mirror 106 sections. These embodiments can therefore provide a better optimization of the gain properties of the active region 102 while still providing the desirable high-saturation-power loss-compensation in the mirrors 106, 108 and/or phase-shift 104 sections. This modification can be accomplished either by selective quantum-well intermixing, selective area growth or by butt-joint regrowth of waveguides of different bandgap. For example, for the quantum-well intermixing embodiments, one can use ion-implantation, of phosphorous above the waveguide 110 to create vacancies that can then be diffused in a heat treatment step to intermix the quantum-wells with the surrounding SCH waveguide 110 material. This intermixing raises the net absorption edge in the quantum wells as well as lowering the absorption edge of the adjacent SCH regions 200. Thus, the disordered regions can now function mostly like passive tuning sections, which have significant index changes resulting from carrier injection. But with the present invention, they still have the desired added gain to compensate loss at high pumping, where the high carrier density lowers the bandgap via band shrinkage sufficiently for band-to-band transitions to occur. Again, the saturation power of the amplification in these intermixed sections is significantly higher than that of the original non-intermixed quantum well/SCH sections. The non-intermixed gain region can now have deeper quantum wells and higher barriers to provide gain more efficiently.

Further optimization is achieved in some of these embodiments by applying two levels of quantum-well intermixing, a variable-width selective-area-growth mask or two regrowth steps to provide three different bandgaps along the laser 100. The gain region 102 is constructed optimally with relatively low quantum-well and a high SCH bandgaps. A first change in bandgap (with a first level of disordering, for example) provides regions with slightly increased quantum-well bandgaps and slightly decreased SCH bandgaps. A second change in bandgap provides passive waveguide regions that can be tuned very efficiently as in conventional SGDBR designs, while having little or no loss compensation. (For example, this can be accomplished with a second level of disordering to almost completely intermix the quantum-wells with the SCH.) The first level of disordering provides regions with moderate levels of gain, but with higher saturation power than for the original non-intermixed regions. These have reduced tuning properties since the carriers are depleted by stimulated recombination, but they have better gain properties.

One of these embodiments uses periodic selective disordering in the SGDBR mirrors with two bandgap regions to optimize the loss compensation with little compromise in tunability. A detailed description of the preferred embodiments follows.

For the first embodiment without any quantum-well disordering, the structure is first grown from the InP base substrate 202 to the top of the SCH waveguide region 110, typically in an MOCVD apparatus using standard epitaxial semiconductor growth techniques. The lower cladding 204 of the substrate 112 is typically n-type InP; the SCH waveguide 110 is typically InGaAsP of ~ 1.45 - 1.5 μm bandgap composition (the exact range to be specified below); the included quantum wells are typically InGaAs or InGaAsP wells, 7-10 nm in thickness, of 1.6 - 1.67 μm bandgap composition. At this point the "base wafer" is then processed to etch the sampled grating grooves into the surface of the SCH waveguide 110 (typically ~ 30 nm deep). Depending upon the type of lateral guiding to be used, the wafer is re-inserted into the growth reactor and additional layers grown. For a ridge or some types of buried heterostructure (BH) lateral waveguides, the upper cladding 206 (typically p-type InP) and contact layers 114 (typically p+InGaAs) are regrown. Then, for a ridge, surrounding material is etched down to the SCH waveguide 110 for lateral confinement, or for the buried heterostructure (BH), a deep ridge is etched down through the SCH and additional semiinsulating or some sort of npnp blocking layers grown to surround the ridge to provide current and optical confinement Other regrowth variations are possible for the cladding and lateral guiding structures as are well known to those skilled in the art; this invention is primarily concerned with the design and formation of the SCH waveguide region 110.

For some embodiments, a selective bandgap change along the length is provided to better optimize the gain and tuning properties of the various sections. If the optional quantum-well disordering of some of the sections is used to reduce the need to overcome most of the quantum-well absorption, the first growth also includes a cladding layer (typically InP) of several hundred nm in thickness. This is then implanted (typically with P) to a depth less than the cladding thickness to create vacancies only in this cladding. These vacancies are then diffused through the SCH waveguide 110 and quantum wells to intermix the wells with the SCH material in an annealing step. Then this first top cladding is removed, removing all ion-implant damage; the gratings formed; and top layers regrown as before.

This selective change in bandgap along the length of the laser 100 can also be accomplished by selective-area growth that uses masking regions of varying width to provide for different composition and thickness quantum-wells and SCH during the first growth. It could also be accomplished by etching away certain regions after the first growth and regrowing the desired bandgap regions on a second growth.

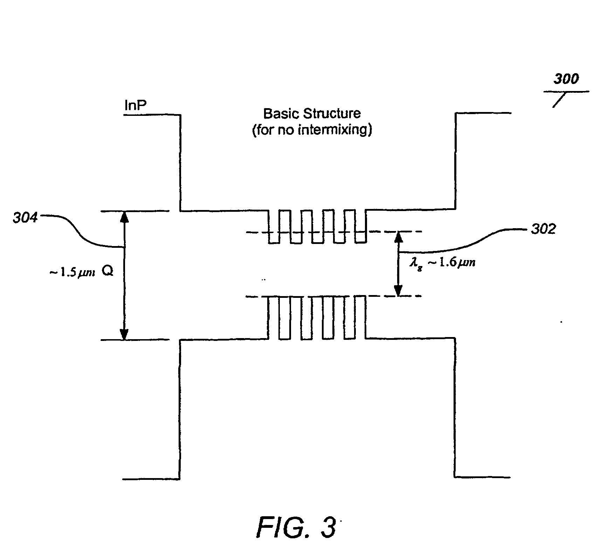

FIG. 3 is a transverse schematic 300 of the energy bands plotted across the SCH waveguide region 110 for the first embodiment in which a single uniform quantum-well SCH waveguide is used throughout the entire device length. InGaAsP/InP materials are assumed but others known to those skilled in the art may be used in a similar way. As shown in FIG. 3, a key aspect of this first embodiment of the present invention is to select the relative bandgap energies or optical absorption edges properly to accomplish the desired gain, tuning and loss properties in the various sections, all from a common waveguide structure.

As illustrated in FIG. 3, the as-grown waveguide guide consists of a relatively low bandgap energy SCH 302 that contains centered shallow quantum wells. This structure is optimized such that gain builds up rapidly in the quantum wells as carriers are injected to a level roughly equal to that required for the device threshold 304. At this point the shallow quantum wells are filled, and some carriers are already spilling out into the SCH region. Thus, with additional carrier injection the gain tends to saturate, having only a slight increase in the desired optical band as additional injected carriers fill the higher bandgap SCH region. However, the build up of carriers in the SCH will provide a desirable index of refraction change. Thus, by altering the relative biases of the various SGDBR laser sections, the various indexes can be adjusted while the net gain still remains at its required threshold value.

The analysis indicates that optimal values for the SCH bandgap is 1 to 2 kT (or 26 to 52 meV larger in energy than the lasing energy, or about 50 to 100 nm lower in wavelength near 1550 nm. The lasing energy is typically approximately equal to the lowest calculated subband transition energy in the quantum-well with no pumping. Bandgap shrinkage reduces the bandgap and this lowest subband energy about 30 meV at typical threshold carrier densities, and the lineshape rounding and state filling combine to put the typical lasing wavelength back at about the same point as the carrier-free calculated subband edge. This separation between the lasing energy and the SCH waveguide absorption edge is much smaller than normal in typical multiple-quantum-well-SCH lasers, where it is usually desired to have good carrier confinement to the quantum wells. The separation results in a gain vs current density characteristic that saturates at relatively low values.

For operation near 1550 nm, the quantum-wells are most desirably composed of compressively strained InGaAs or InGaAsP with about 1% strain, although various other well designs may work relatively well. Varying the strain and composition will result in wells of different widths; the ternary wells, with the most compressive strain, will be narrowest with the lowest saturated gain, and the quaternary wells, with the least compressive strain, will be the widest with the largest saturated gain. The number of wells and the width desired will depend upon the cavity loss of the particular device under consideration. Generally, the gain should saturate at about the threshold gain level So, the specification is to select the number of wells and composition to achieve this condition.

With this design the carrier density in the SCH regions can be modulated by varying the bias currents to the various sections. This modulation in turn varies the refractive index and the optical path length and/or Bragg wavelength of the particular section in question to tune the laser. Thus, the currents to the various electrodes have somewhat the same function as in the prior-art SGDBR laser. However, it is generally necessary to reduce the bias in one section at the same time it is increased in another due to the clamping of the net modal gain in the device to its threshold value. This effect is minimized by operating in the saturated region of the gain curve, but it still suggests that best tuning is accomplished by simultaneously decreasing one current while increasing another.

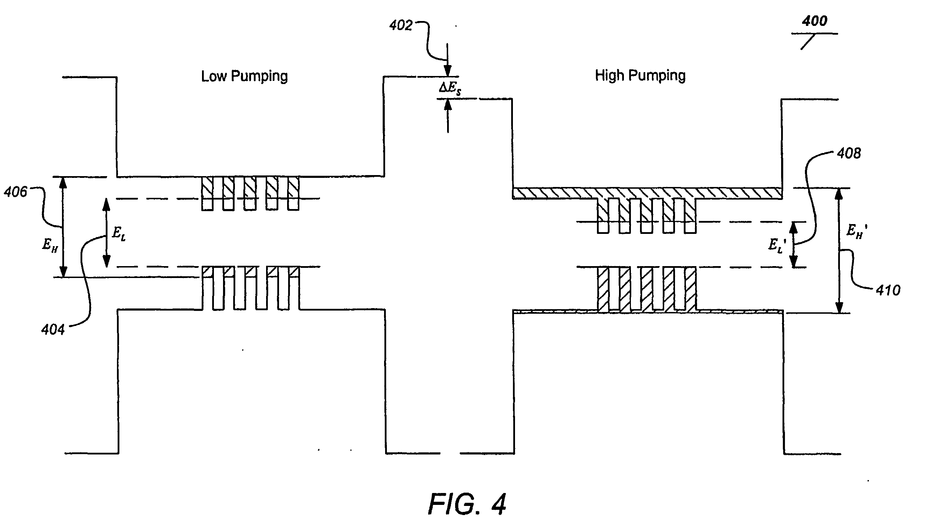

FIG. 4 illustrates the band structure 400 at low and high carrier injection levels (i.e. low and high pumping). The unwanted loss associated with the build-up of carriers in the SCH region is partially compensated by slight increases in modal gain associated with band-to-band transitions that now can exist in the SCH due to significant band shrinkage 402, $\Delta E_S$, which lowers the SCH bandgap to fall within the lasing wavelength range at high carrier densities where the material is inverted. As illustrated in FIG. 4, at high injection levels the carriers spill out of the quantum wells to fill the SCH region. This provides the change in refractive index. However, the band shrinkage 402, $\Delta E_S$, now moves the bandgap of the SCH to be below the lasing transition energy. Fortunately, at the conduction/valence band state, occupation is inverted so that net gain results. These effects, together with the fact that there is gain compensation of passive and scattering losses in the first place with proper biasing, leads to output powers much higher than possible with prior art designs. FIG. 4 illustrates the low and high energy levels at low pumping 404, 406 relative to the low and high energy levels at high pumping 408,410.

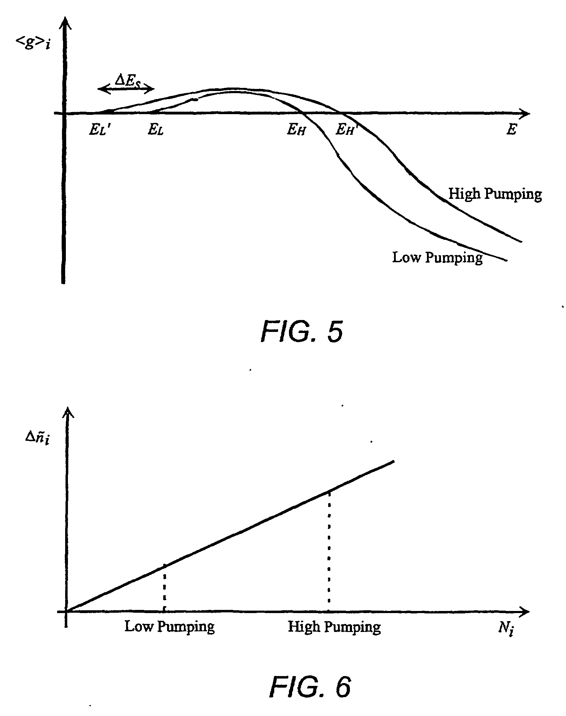

FIGS. 5 and 6 further explain the modal gain/loss characteristics of a typical section having the basic design of the current invention. The same two pumping levels suggested in FIG. 4 are considered. FIG. 5 illustrates the modal gain vs. energy for the carrier densities of FIG. 4. FIG. 6 shows the modal index vs. carrier density.

FIG. 5 sketches the gain for the two pumping levels of FIG. 4. The first is for moderate pumping, which might typically be sufficient to provide the threshold modal gain level for the center wavelength if all sections were pumped equally. Positive gain extends from a low energy 404, $E_L$, the energy separation of the unperturbed subband edges, to a high energy 406, $E_H$, which extends from the conduction band edge of the SCH (suggesting a large percentage of carriers in the SCH) to some valence band energy still below the quantum-well barrier. It is important to realize that with a large percentage of carriers in the SCH, there is still a much higher carder density in the quantum wells. That is, the modal index tuning, and thus wavelength tuning, is still small as shown in FIG. 6. The second curve illustrates the gain under high pumping. It may be necessary to reduce the pumping slightly elsewhere to avoid carrier clamping, but as shown, there is little gain increase at any one wavelength, so this is may not be necessary. The important point is that the carrier density in the SCH is much higher, and this provides significant tuning as shown in FIG. 6. The gain spectrum is significantly broadened, from a low energy 408, $E_L'$ to a high energy 410, $E_H'$, but there is little increase at its peak due to the saturation of available states in the lasing band.

The gain characteristics of FIG. 5 also indicate that the saturation power for this configuration should be large. As may be found in various works, for example by Equations (8.18) through (8.24) in Chapter 8 of <u>Diode Lasers and Photonic Integrated Circuits</u>, by L. Coldren and S. Corzine, 1995, which is incorporated by reference herein, the saturation characteristics of the incremental gain $g$, for an optical power, $P$, are given by,

$$g = \frac{g_0}{1 + P/P_s}$$

where $g_0$ is the small-signal gain, and the saturation power,

$$P_s = \frac{wd(h\upsilon)}{\alpha \Gamma_{XY} \tau}$$

The parameters, $w$ and $d$ are the width and thickness of the active region containing the carriers, $(h\upsilon)$ is the photon energy, $\alpha$ is the differential gain, $dg/dN$, $\Gamma_{xy}$ is the transverse confinement factor measuring the relative gain/optical mode overlap, and $\tau$ is the carrier lifetime. Now as the carriers spill out into the SCH region giving characteristics as shown in FIG. 5, the differential gain, $\alpha$, becomes small (less than 20% of the best quantum-well gain regions), and the thickness $d$ , containing carriers, increases more than the confinement factor, $\Gamma_{XY}$. Thus, the saturation power increases by several times, enabling the output power to be several tens of milliwatts.

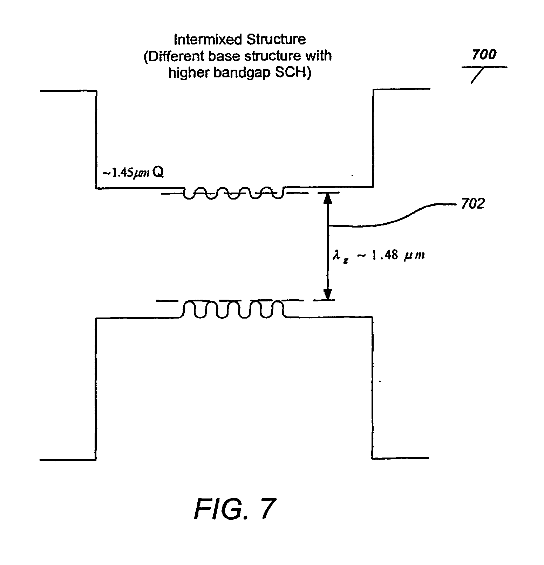

FIG. 7 shows the band structure 700 of an intermixed section (or one formed by selective-area growth or butt-joint regrowth) that exists in another embodiment where a change in bandgap in the mirror and/or phase-shift regions is created. The original growth also begins with a higher bandgap SCH to better optimize the active region. After intermixing the quantum well bandgap is raised and the SCH bandgap 702 reduced slightly to provide more optimum operation of both the gain and tuning sections. Typical SCH bandgap values of the starting material in this case would be from 1.45 to 1.4 μm. The SCH bandgap 702 of the intermixed structure 700 is higher than the SCH bandgap of the non-intermixed structure 300.

Yet another embodiment of the present invention reduces the effects of gain clamping on the freedom to vary the carrier density in any one section as well as the need to bias each section to at least transparency. In this case, the device works more similar to the prior art SGDBR laser with the important exception that we still get some measure of loss compensation of the free-carrier absorption. This occurs if the disordered quantum-well region has a bandgap 1 - 2 kT more than the center of the lasing wavelength band. Thus, at higher pumping levels where higher numbers of carriers are being injected, band shrinkage move the bandedge of the SCH down to the level where band-to-band transitions are possible in the SCH at the lasing wavelength. Thus, in the gain region where there is no intermixing, a somewhat higher bandgap SCH region exists to provide better carrier confinement, while in the intermixed regions the desired loss compensation at higher pumping levels still exists. Thus, there is less compromise in the desirable individual properties of the various sections.

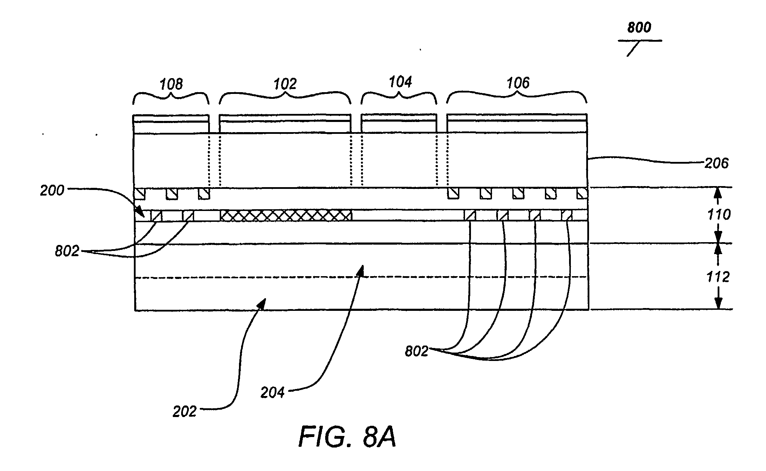

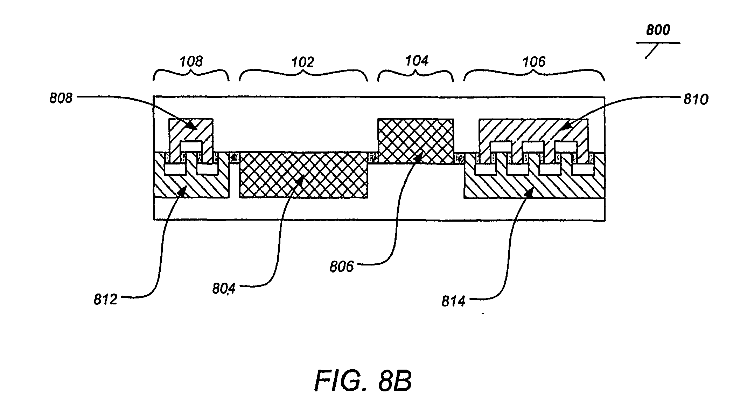

FIGS. 8A - 8B illustrate an embodiment in which three different bandgap regions are created. The two lower bandgap regions 802 are placed periodically in the SGDBR mirror sections 106,108 as illustrated in FIG 8A. FIG. 8B illustrates a possible separate electrical connection to two of these that are situated in the SGDBR mirror sections 106, 108. The electrical contacts for the gain section 804 and the phase section 806 are shown as typical The front and back mirrors 108, 106 each have gain contacts 808, 810 interlaced with tuning contacts 812, 814. This is not essential, but it will provide more optimized operation, but at the expense of having an additional current port in each mirror. Here, the SCH region in the gain section can have a still larger bandgap (~1.3-1.4 μm) and quantum-wells optimized for the most efficient operation of this section; the first disordered region (second bandgap) will intermix the quantum-wells to have a bandgap that is slightly increased and an SCH that is slightly reduced. The volume of carrier confinement will also be at least doubled This region is used for gain in the mirrors. This is desirable because it will have a somewhat higher satutation power than the optimized quantum-well gain region material and still have good gain properties over most of the wavelength band. Bandgap shrinkage will again enable this since higher carrier densities will be necessary to provide good gain as compared to the optimized non-intermixed gain section. The second disordered region (third bandgap) will fully intermix the quantum-wells and the SCH to provide optimum tuning characteristics, but with no loss compensation. The partially intermixed gain region will be placed periodically in the mirrors to provide the loss compensation with relatively high saturation power.

As will be evident to those skilled in the art, the principle of the foregoing embodiments of this invention may also be used in creating optimized integrated amplifiers and modulators, as have been described in commonly-assigned and copending U.S. utility patent applications, Serial No. 09/614,224, filed July, 12, 2000, by Larry A. Coldren et al, and entitled "METHOD OF MAKING A TUNABLE LASER SOURCE WITH INTEGRATED OPTICAL AMPLIFIER" (now U.S. Patent No. 6,654,400 issued November 25, 2003); Serial No. 09/614,377, filed July, 12, 2000, by Larry A. Coldren, and entitled "INTEGRATED OPTO-ELECTRONIC WAVELENGTH CONVERTER ASSEMBLY" (now U.S. Patent No. 6,580,739 issued June 17, 2003); Serial No. 09/614,376, filed July, 12, 2000, by Larry A. Coldren et al., and entitled "METHOD OF CONVERTING AN OPTICAL WAVELENGTH WITH AN OPTO-ELECTRONIC LASER WITH INTEGRATED MODULATOR" (now U.S. Patent No. 6,614,819 issued September 2, 2003); Serial No. 09/614,378, filed July, 12, 2000, by Larry A. Coldren et al., and entitled "OPTO-ELECTRONIC LASER WITH INTEGRATED MODULATOR" (now U.S. Patent No. 6,628,690 issued September 30, 2003); Serial No. 09/614,895, filed July, 12, 2000, by Larry A. Coldren, and entitled "METHOD FOR CONVERTING AN OPTICAL WAVELENGTH USING A MONOLITHIC WAVELENGTH CONVERTER ASSEMBLY" (now U.S. Patent No. 6,349,106 issued February 19, 2002); Serial No. 09/614,375, filed July, 12, 2000, by Larry A. Coldren et al., and entitled "TUNABLE LASER SOURCE WITH INTEGRATED OPTICAL AMPLIFIER" (now U.S. Patent No. 6,658,036 issued December 2, 2003); Serial No. 09/614,195, filed July, 12, 2000, by Larry A. Coldren et al., and entitled "METHOD OF MAKING AND OPTO-ELECTRONIC LASER WITH INTEGRATED MODULATOR" (now U.S. Patent No. 6,514,259 issued June 3, 2003); Serial No. 09/614,665, filed July, 12,2000, by Larry A. Coldren et al., and entided "METHOD OF GENERATING AN OPTICAL SIGNAL WITH A TUNABLE LASER SOURCE WITH INTEGRATED OPTICAL AMPLIFIER" (now U.S. Patent No. 6,687,278 issued February 3, 2004) ; Serial No. 09/614,674, filed July, 12, 2000, by Larry A. Coldren, and entitled "METHOD FOR MAKING A MONOLITHIC WAVELENGTH CONVERTER ASSEMBLY" (now U.S. Patent No. 6,624,000 issued September 23, 2003); all of which are continuation-in-parts of the others, and all of which claim the benefit under 35 U.S.C. §119(e) to the following U.S. provisional patent applications: Serial No. 60/152,038, filed on September 2,1999, by Gregory Fish et al., and entitled "OPTOELECTRONIC LASER WITH INTEGRATED MODULATOR"; Serial No. 60/152,049, filed on September 2,1999, by Larry Coldren, and entitled "INTEGRATED OPTOELECTRONIC WAVELENGTH CONVERTER"; and Serial No. 60/152,072, filed on September 2, 1999, by Beck Mason et al., and entitled "TUNABLE LASER SOURCE WITH INTEGRATED OPTICAL AMPLIFIER."

This concludes the description of the preferred embodiment of the present invention. In summary, the present invention discloses a tunable laser including a gain section for creating a light beam by stimulated and spontaneous emission over a bandwidth, a phase section for controlling the light beam around a center frequency of the bandwidth. a waveguide for guiding and reflecting the light beam in a cavity including a relatively low energy bandgap separate-confinement-heterostructure (SCH), a front mirror bounding an end of the cavity and a back mirror bounding an opposite end of the cavity wherein gain is provided by at least one of the group comprising the phase section, the front mirror and the back mirror.

The foregoing description of one or more embodiments of the invention has been presented for the purposes of illustration and description. It is not intended to be exhaustive or to limit the invention to the precise form disclosed. Many modifications and variations are possible in light of the above teaching. It is intended that the scope of the invention be limited not by this detailed description, but rather by the claims appended hereto.

**Claims**

1. A sampled-grating distributed Bragg reflector (SGDBR) tunable laser (100) comprising:

   a gain section (102) for creating a light beam;

   a phase section (104) for controlling the light beam around a center frequency of the bandwidth;

   a front distributed Bragg reflector (DBR) mirror (108) bounding an end of the cavity; and

   a back distributed Bragg reflector (DBR) mirror (106) bounding an opposite end of the cavity;

   a waveguide (110) for guiding and reflecting the light beam in a cavity including a relatively low energy bandgap separate-confinement-heterostructure (SCH) (200), the waveguide including the SCH being uniform across the gain and phase sections and the front and back mirrors, and the SCH including centered shallow quantum wells;

   wherein gain for the light beam is provided by at least one of the group comprising the phase section, the front mirror and the back mirror.

2. The laser of claim 1, wherein the gain provided by at least one of group comprising the phase section, the front mirror and the back minor has a saturation power higher than substantially 5 mW.

3.  The laser of claim 1 or claim 2, wherein the SCH is optimized such that the gain builds up rapidly in the centered shallow quantum wells to a level substantially equal to that required for a device threshold (304).

4.  The laser of any one of claims 1 to 3, wherein each of the gain and phase sections and front and back mirrors has an index that is separately adjustable by biases separately alterable at each.

5.  The laser of claim 4, wherein relative biases of the gain and phase sections and front and back mirrors are alterable to adjust the indexes while a net gain remains at a device threshold.

6.  The laser of any one of claims 1 to 5, wherein free-carrier absorption loss resulting from a build up of carriers in the SCH is at least partially compensated for by the gain provided by at least one of the group comprising the phase section, the front mirror and the back mirror.

7.  The laser of any preceding claim, wherein the gain provided by the at least one of the group comprising the phase section, the front mirror and the back mirror is modified by a process selected from the group comprising selective quantum well intermixing, selective area growth and butt-joint regrowth of waveguides of different bandgaps.

8.  The laser of any preceding claim, wherein gain is provided by more than one of the group comprising the phase section, the front mirror and the back mirror and each gain is separately modified by a process selected from the group comprising selective quantum well intermixing, selective area growth and butt-joint regrowth of waveguides of different bandgaps.

9.  The laser of claim 8, wherein gain is provided by the front mirror modified by selective quantum well intermixing and gain is provided by the back mirror modified by selective quantum well intermixing wherein each intermixing produces different bandgap regions.

10. The laser of claim 8 or claim 9, wherein the gain section has relatively low quantum well and high SCH bandgaps.

11. The laser of any preceding claim, wherein the gain provided by at least one of the group comprising the phase section, the front minor and the back mirror is applied through an electrical contact interlaced with a tuning electrical contact.

12. A method of producing a sampled-grating distributed Bragg reflector (SGDBR) semiconductor laser (100), comprising the steps of

    growing a waveguide layer (110) for guiding and reflecting the light beam including a relatively low energy bandgap separate-confinement-heterostrueture (SCH) region (200) on a substrate (112) including a gain section (102) for creating a light beam, a phase section (104) for controlling the light beam around a center frequency of the bandwidth, a front mirror (108) bounding an end of the cavity and a back mirror (106) bounding an opposite end of the cavity, the waveguide layer including the SCH being uniform across the gain and phase sections and the front and back mirrors and the SCH including centered shallow quantum wells;

    etching sampled grating grooves in the waveguide layer to form the front mirror and the back mirror, and

    growing upper cladding (206) and contact layers (114) on the waveguide layer,

    wherein gain is provided by at least one of the group comprising the phase section, the front mirror and the back mirror.

13. The method of claim 12, wherein the gain provided by at least one of group comprising the phase section, the front mirror and the back mirror has a saturation power higher than substantially 5 mW.

14. The method of claim 12 or claim 13, wherein the SCH is optimized such that the gain builds up rapidly to a level substantially equal to that required for a device threshold (304).

15. The method of any one of claims 12 to 14, wherein each of the gain and phase sections and front and back mirrors has an index that is separately adjustable by biases separately alterable at each.

16. The method of claim 15, wherein the indexes are adjustable while a net gain remains at a device threshold.

17. The method of any one of claims 12 to 16, wherein free-carrier absorption loss resulting from a build up of carriers in the SCH is at least partially compensated for by the gain provided by at least one of the group comprising the phase section, the front mirror and the back mirror.

18. The method of any one of claims 12 to 17, wherein the gain provided by the at least one of the group comprising the phase section, the front mirror and the back mirror is modified by a process selected from the group comprising selective quantum well intermixing, selective area growth and butt-joint regrowth of waveguides of different bandgaps.

19. The method of any one of claims 12 to 18, wherein gain is provided by more than one of the group comprising the phase section, the front mirror and the back mirror and each gain is separately modified by a process selected from the group comprising selective quantum well intermixing, selective area growth and butt-joint regrowth of waveguides of different bandgaps.

20. The method of claim 19, wherein gain is provided by the front mirror modified by selective quantum well intermixing and gain is provided by the back mirror modified by selective quantum well intermixing wherein each intermixing produces different bandgap regions.

21. The method of claim 19 or claim 20, wherein the gain section has relatively low quantum well and high SCH bandgaps.

22. The method of any one of claims 12 to 21, wherein the gain provided by at least one of the group comprising the phase section, the front mirror and the back mirror is applied through an electrical contact interlaced with a tuning electrical contact.

**Patentansprüche**

1. Ein abstimmbarer Bragg-Reflektorlaser mit sampled grating bzw. abgetastetem Gitter (100) (SGDBR), der aufweist:

    einen Verstärkungsabschnitt (102) für das Erzeugen eines Lichtstrahls,
    einen Phasenabschnitt (104) für das Einstellen des Lichtstrahls in der Nähe einer Zentralfrequenz der Bandbreite,
    einen vorderen Spiegel (108) des verteilten Bragg-Reflektors (DBR), der ein Ende der Kavität begrenzt,
    einen hinteren Spiegel (106) des verteilten Bragg-Reflektors (DDR), der ein entgegengesetztes Ende der Kavität begrenzt,
    einen Wellenleiter (110) für das Führen und Reflektieren des Lichtstrahls in einer Kavität einschließlich einer separate confinement Heterostruktur (SCH) mit einer Bandlücke mit relativ niedriger Energie (200), wobei der Wellenleiter, der die SCH beinhaltet, gleichförmig über den Verstärkungsabschnitt und den Phasenabschnitt und über den vorderen und hinteren Spiegel und die SCH ist, die zentrierte flache Quantenwells beinhaltet,

    wobei die Verstärkung des Lichtstrahls von zumindest einem aus der Gruppe, die besteht aus dem Phasenabschnitt, dem vorderen Spiegel und dem hinteren Spiegel, bereitgestellt wird.

2. Laser nach Anspruch 1, in dem die Verstärkung, die von zumindest einem aus der Gruppe bereitgestellt wird, die besteht aus dem Phasenabschnitt, dem vorderen Spiegel und dem hinteren Spiegel, eine Sättigungsleistung hat, die höher als im wesentlichen 5 mW ist.

3. Laser nach Anspruch 1 oder Anspruch 2, in dem die SCH derart optimiert ist, daß die Verstärkung sich abrupt in den zentrierten flachen Quantenwells auf ein Niveau aufbaut, das im wesentlichen gleich dem ist, das für einen Geräteschwellwert (304) erforderlich ist.

4. Laser nach einem der Ansprüche 1 bis 3, in dem der Verstärkungs- und der Phasenabschnitt und der vordere und der hintere Spiegel einen Index haben, der getrennt durch Vorspannungen, die getrennt bei jedem veränderbar sind, einstellbar ist.

5. Laser nach Anspruch 4, in dem die relativen Vorspannungen des Verstärkungs- und des Phasenabschnitts und des vorderen und hinteren Spiegels veränderbar sind, um die Indizes einzustellen, während eine Gesamtverstärkung bei einem Geräteschwellwert bleibt.

6. Laser nach einem der Ansprüche 1 bis 5, in dem der Absorptionsverlust der freien Träger, der von dem Aufbau von Trägern in der SCH herrührt, zumindest teilweise durch die Verstärkung kompensiert wird, die von zumindest einem aus der Gruppe bereitgestellt wird, die besteht aus dem Phasenabschnitt, dem vorderen Spiegel und dem hinteren Spiegel.

7. Laser nach einem der vorherigen Ansprüche, in dem die Verstärkung, die von mindestens einem der Gruppe bereitgestellt wird, die besteht aus dem Phasenabschnitt, dem vorderen Spiegel und dem hinteren Spiegel, durch einen Prozeß modifiziert wird, der ausgewählt wird aus der Gruppe, die besteht aus dem selektiven Quantenwellmischen, dem selektiven Bereichswachstum und dem Stoßverbindungsneuwachsen von Wellenleitem mit unterschiedlichen Bandlücken.

8. Laser nach einem der vorherigen Ansprüche, bei dem die Verstärkung durch mehr als ein Element aus der Gruppe bereitgestellt wird, die besteht aus dem Phasenabschnitt, dem vorderen Spiegel und dem hinteren Spiegel, und wobei jede Verstärkung getrennt modifiziert wird durch einen Prozeß bzw. ein Verfahren, das ausgewählt wird aus der Gruppe, die besteht aus dem selektiven Quantenwellmischen, dem selektiven Bereichswachstum und dem Stoßverbindungsneuwachsen von Wellenleitern unterschiedlicher Bandlücken.

9. Laser nach Anspruch 8, in dem die Verstärkung bereitgestellt wird durch den vorderen Spiegel, die modifiziert wird durch die selektive Quantenwellmischung, und in dem Verstärkung bereitgestellt wird durch den hinteren Spiegel, die modifiziert wird durch das selektive Quantenwellmischen, wobei jedes Mischen unterschiedliche Bandlückenbereiche erzeugt.

10. Laser nach Anspruch 8 oder Anspruch 9, in dem der Verstärkungsabschnitt relativ geringe Quantenwell- und hohe SCH-Bandlücken hat.

11. Laser nach einem der vorherigen Ansprüche, in dem die Verstärkung, die von zumindest einem Element der Gruppe bereitgestellt wird, die besteht aus dem Phasenabschnitt, dem vorderen Spiegel und dem hinteren Spiegel, über einen elektrischen Kontakt, der mit einem elektrischen Abstimmkontakt verzahnt ist, angelegt wird.

12. Verfahren zum Erzeugen eines Bragg-Reflektorhalbleiterlasers (100) mit sampled grating (SGDBR), das die Schritte aufweist:

Wachsen einer Wellenleiterschicht (110) für das Führen und Reflektieren des Lichtstrahls einschließlich einer separable confinement Heterostrukturregion (SCH) mit relativ niedriger Energiebandlücke (200) auf einem Substrat (112) einschließlich eines Verstärkungsabschnitts (102) für das Erzeugen eines Lichtstrahls, eines Phasenabschnitts (104) für das Einstellen des Lichtstrahls in der Nähe einer Zentralfrequenz der Bandbreite, einen vorderen Spiegel (108), der ein Ende der Kavität begrenzt, und einen hinteren Spiegel (106), der ein gegenüberliegendes Ende der Kavität begrenzt, wobei die Wellenleiterschicht einschließlich der SCH gleichförmig über den Verstärkungs- und Phasenabschnitten und dem vorderen und dem hinteren Spiegel und der SCH einschließlich der zentrierten flachen Quantenwells ist,
Ätzen von sampled-grating-Nuten in der Wellenleiterschicht, um den vorderen Spiegel und den hinteren Spiegel zu bilden, und
Wachsen bzw. Züchten einer oberen Umhüllung (206) und von Kontaktschichten (114) auf der Wellenleiterschicht,

wobei die Verstärkung bereitgestellt wird von zumindest einem aus der Gruppe, die besteht aus dem Phasenabschnitt, dem vorderen Spiegel und dem hinteren Spiegel.

13. Verfahren nach Anspruch 12, in dem die Verstärkung, die von zumindest einem aus der Gruppe bereitgestellt wird, die besteht aus dem Phasenabschnitt, dem vorderen Spiegel und dem hinteren Spiegel, eine Sättigungsenergie hat, die größer als im wesentlichen 5 mW ist.

14. Verfahren nach Anspruch 12 oder Anspruch 13, in dem die SCH derart optimiert ist, daß sich die Verstärkung abrupt auf ein Niveau aufbaut, das im wesentlichen gleich demjenigen ist, das für einen Geräteschwellwert (304) erforderlich ist.

15. Verfahren nach einem der Ansprüche 12 bis 14, in dem jeder, der Verstärkungs- und der Phasenabschnitt und der vordere und der hintere Spiegel einen Index hat, der getrennt einstellbar ist durch Vorspannungen, die bei jedem getrennt veränderbar sind.

16. Verfahren nach Anspruch 15, bei dem die Indizes einstellbar sind, während eine Gesamtverstärkung bei einem Geräteschwellwert verbleibt.

17. Verfahren nach einem der Ansprüche 12 bis 16, in dem der Absorptionsverlust der freien Träger, der von dem Aufbau von Trägern in der SCH herrührt, zumindest teilweise kompensiert wird durch die Verstärkung, die von zumindest einem aus der Gruppe bereitgestellt wird, die besteht aus dem Phasenabschnitt, dem vorderen Spiegel und dem hinteren Spiegel.

18. Verfahren nach einem der Ansprüche 12 bis 17, bei dem die Verstärkung, die von zumindest einem aus der Gruppe bereitgestellt, die besteht aus dem Phasenabschnitt, dem vorderen Spiegel und dem hinteren Spiegel, modifiziert wird durch ein Verfahren, das aus der Gruppe ausgewählt wird, die besteht aus dem selektiven Quantenwellmischen, dem selektiven Flächenwachstum und dem Stoßverbindungsneuwachsen von Wellenleitem mit unterschiedlichen Bandlücken.

19. Verfahren nach einem der Ansprüche 12 bis 18, in dem die Verstärkung bereitgestellt wird von mehr als einem aus der Gruppe, die besteht aus dem Phasenabschnitt, dem vorderen Spiegel und dem hinteren Spiegel, und wobei jede Verstärkung getrennt modifiziert wird durch einen Prozeß, der aus der Gruppe ausgewählt wird, die besteht aus dem selektiven Quantenwellmischen, dem selektiven Flächenwachstum und dem Stoßverbindungsneuwachsen von Wellenleitem unterschiedlicher Bandlücken.

20. Verfahren nach Anspruch 19, in dem die Verstärkung bereitgestellt wird durch den vorderen Spiegel, der modifiziert wird durch das selektive Quantenwellmischen, und die Verstärkung bereitgestellt wird durch den hinteren Spiegel. die durch das selektive Quantenwellmischen modifiziert wird, wobei jedes Mischen unterschiedliche Bandlückenregionen erzeugt.

21. Verfahren nach Anspruch 19 oder Anspruch 20, in dem der Verstärkungsabschnitt relativ niedrige Quantenwell- und hohe SCH-Bandlücken hat.

22. Verfahren nach einem der Ansprüche 12 bis 21, in dem die Verstärkung, die von zumindest einem aus der Gruppe bereitgestellt wird, die besteht aus dem Phasenabschnitt, dem vorderen Spiegel und dem hinteren Spiegel, über einen elektrischen Kontakt angelegt wird, der mit einem elektrischen Abstimmkontakt verzahnt ist.

**Revendications**

1. Laser accordable (100) à réflecteur Bragg distribué à réseau échantillonné (SGDBR) comprenant :

une section de gain (102) pour créer un faisceau lumineux ;
une section de phase (104) pour commander le faisceau lumineux au voisinage d'une fréquence centrale de la largeur de bande ;
un miroir (108) de réflecteur Bragg distribué (DBR) avant délimitant une extrémité de la cavité ; et
un miroir (106) de réflecteur Bragg distribué (DBR) arrière délimitant une extrémité opposée de la cavité ;
un guide d'ondes (110) pour guider et réfléchir le faisceau lumineux dans une cavité comportant une hétérostructure à confinement séparé (SCH) à bande interdite d'énergie relativement faible (200), le guide d'ondes comportant le SCH étant uniforme sur la totalité des sections de gain et de phase et des miroirs avant et arrière, et l'hétérostructure SCH comportant des puits quantiques centrés peu profonds;

dans lequel le gain destiné au faisceau lumineux est produit par au moins l'un du groupe comprenant la section de phase, le miroir avant et le miroir arrière.

2. Laser selon la revendication 1, dans lequel le gain produit par au moins l'un du groupe comprenant la section de phase, le miroir avant et le miroir arrière a une puissance à saturation supérieure à environ 5 mW.

3. Laser selon la revendication 1 ou 2, dans lequel l'hétérostructure SCH est optimisée afin que le gain s'accumule rapidement dans les puits quantiques centrés peu profonds à un niveau sensiblement égal à celui exigé pour un seuil de dispositif (304).

4. Laser selon l'une quelconque des revendications 1 à 3, dans lequel chacune des sections de gain et de phase et chacun des miroirs avant et arrière a un indice qui est réglable séparément par des polarisations modifiables séparément sur chacun d'eux.

5. Laser selon la revendication 4, dans lequel les polarisations relatives des sections de gain et de phase et des miroirs avant et arrière sont modifiables pour régler les indices alors que le gain net reste à un seuil de dispositif.

6. Laser selon l'une quelconque des revendications 1 à 5, dans lequel la perte par absorption de porteurs libres résultant d'une accumulation de porteurs dans l'hétérostructure SCH est au moins partiellement compensée par le gain produit par au moins l'un du groupe comprenant la section de phase, le miroir avant et le miroir arrière.

7. Laser selon l'une quelconque des revendications précédentes, dans lequel le gain produit par au moins l'un du groupe comprenant la section de phase, le miroir avant et le miroir arrière est modifié par un traitement sélectionné dans le groupe comprenant le mélange mutuel sélectif de puits quantiques, la croissance surfacique sélective et la recroissance bout à bout de guides d'ondes de bandes interdites différentes.

8. Laser selon l'une quelconque des revendications précédentes, dans lequel le gain est produit par plus de l'un du groupe comprenant la section de phase, le miroir avant et le miroir arrière et chaque gain est modifié séparément par un traitement sélectionné dans le groupe comprenant le mélange mutuel sélectif de puits quantiques, la croissance surfacique sélective et la recroissance bout à bout de guides d'ondes de bandes interdites différentes.

9. Laser selon la revendication 8, dans lequel le gain est produit par le miroir avant modifié par le mélange mutuel sélectif de puits quantiques et le gain est produit par le miroir arrière modifié par mélange mutuel sélectif de puits quantiques, dans lequel chaque mélange mutuel produit des régions de bandes interdites différentes.

10. Laser selon la revendication 8 ou 9, dans lequel la section de gain a un puits quantique relativement faible et des bandes interdites SCH relativement élevées.

11. Laser selon l'une quelconque des revendications précédentes, dans lequel le gain produit par au moins l'un du groupe comprenant la section de phase, le miroir avant et le miroir arrière est appliqué par l'intermédiaire d'un contact électrique entrelacé avec un contact électrique d'accord.

12. Procédé de production d'un laser à semiconducteur (100) à réflecteur Bragg distribué à réseau échantillonné (SGDBR), comprenant les étapes consistant à :

> faire croître une couche de guide d'ondes (110) pour guider et réfléchir le faisceau lumineux, comportant une région (200) d'hétérostructure à confinement séparé (SCH) à bande interdite d'énergie relativement faible sur un substrat (112) comportant une section de gain (102) pour créer un faisceau lumineux, une section de phase (104) pour commander le faisceau lumineux au voisinage d'une fréquence centrale de la largeur de bande, un miroir avant (108) délimitant une extrémité de la cavité et un miroir arrière (106) délimitant une extrémité opposée de la cavité, la couche de guide d'ondes comportant l'hétérostructure SCH étant uniforme sur l'étendue des sections de gain et de phase et des miroirs avant et arrière et l'hétérostructure SCH comportant des puits quantiques centrés peu profonds;
> graver des stries de réseau échantillonné dans la couche de guide d'ondes pour former le miroir avant et le miroir arrière ; et
> faire croître une gaine supérieure (206) et des couches de contact (114) sur la couche de guide d'ondes;
>
> dans lequel le gain est produit par au moins l'un du groupe comprenant la section de phase, le miroir avant et le miroir arrière.

13. Procédé selon la revendication 12, dans lequel le gain produit par au moins l'un du groupe comprenant la section de phase, le miroir avant et le miroir arrière a une puissance à saturation supérieure à environ 5 mW.

14. Procédé selon la revendication 12 ou 13, dans lequel l'hétérostructure SCH est optimisée afin que le gain s'accumule rapidement à un niveau sensiblement égal à celui exigé pour un seuil de dispositif (304).

15. Procédé selon l'une quelconque des revendications 12 à 14, dans lequel chacune des sections de gain et de phase et chacun des miroirs avant et arrière a un indice qui est réglable séparément par des polarisations modifiables séparément sur chacun d'eux.

16. Procédé selon la revendication 15, dans lequel les indices sont réglables alors que le gain net reste à un seuil de dispositif.

17. Procédé selon l'une quelconque des revendications 12 à 16, dans lequel la perte par absorption de porteurs libres résultant d'une accumulation de porteurs dans l'hétérostructure SCH est au moins partiellement compensée par le gain produit par au moins l'un du groupe comprenant la section de phase, le miroir avant et le miroir arrière.

18. Procédé selon l'une quelconque des revendications 12 à 17, dans lequel le gain produit par ledit au moins un du groupe comprenant la section de phase, le miroir avant et le miroir arrière est modifié par un traitement sélectionné dans le groupe comprenant le mélange mutuel sélectif de puits quantiques, la croissance surfacique sélective et la recroissance bout à bout de guides d'ondes de bandes interdites différentes.

19. Procédé selon l'une quelconque des revendications 12 à 18, dans lequel le gain est produit par plus de l'un du groupe comprenant la section de phase, le miroir avant et le miroir arrière et chaque gain est modifié séparément par un traitement sélectionné dans le groupe comprenant le mélange mutuel sélectif de puits quantiques, la croissance surfacique sélective et la recroissance bout à bout de guides d'ondes de bandes interdites différentes.

20. Procédé selon la revendication 19, dans lequel le gain est produit par le miroir avant modifié par mélange mutuel sélectif de puits quantiques et le gain est produit par le miroir arrière modifié par le mélange mutuel sélectif de puits quantiques, dans lequel chaque mélange mutuel produit des régions de bandes interdites différentes.

21. Procédé selon la revendication 19 ou 20, dans lequel la section de gain a un puits quantique relativement faible et des bandes interdites SCH relativement élevées.

22. Procédé selon l'une quelconque des revendications 12 à 21, dans lequel le gain produit par au moins l'un du groupe comprenant la section de phase, le miroir avant et le miroir arrière est appliqué par l'intermédiaire d'un contact électrique entrelacé avec un contact électrique d'accord.

FIG. 1A

FIG. 1B

EP 1 290 765 B1

*FIG. 2*

EP 1 290 765 B1

InP

Basic Structure
(for no intermixing)

*300*

*304*

~1.5μm Q

*302*

$\lambda_g \sim 1.6 \mu m$

FIG. 3

EP 1 290 765 B1

*FIG. 4*

FIG. 5

FIG. 6

Intermixed Structure
(Different base structure with
higher bandgap SCH)

700

~1.45μm Q

702

$\lambda_g \sim 1.48 \ \mu m$

FIG. 7

FIG. 8A

EP 1 290 765 B1

FIG. 8B